# EUROPEAN PATENT APPLICATION

(11) **EP 2 546 319 A1**
(43) Date of publication of application: **16.01.2013**
(21) Application number: 11173804.3
(22) Date of filing: 13.07.2011
(51) Int. Cl.: C09K 11/00

(54) **High efficiency plastic light conversion components by incorporation of phosphor in a polymer by adding to monomers before polymerisation**

(71) Applicant: Koninklijke Philips Electronics N.V., 5621 BA Eindhoven (NL)
(72) Inventor: Jansen, Johannes, M., 5600 AE Eindhoven (NL); Wegh, René, T., 5600 AE Eindhoven (NL)
(74) Representative: Damen, Daniel Martijn

(57) **Abstract**

The invention relates to a method for producing a polymer product having integrated luminescent material particles, the polymer product being produced from at least one monomer in liquid phase and at least one kind of powder of luminescent material particles. The method is characterized by adding the luminescent material to the liquid monomer before polymerisation. The invention further relates to a plastic component for light conversion made of the polymer produced according to said method; a Light-emitting device comprising said plastic component; and the use of a polymer produced according to said method.

## Description

### FIELD OF THE INVENTION

The present invention relates generally to a method for manufacturing a polymer having integrated luminescent material particles. More particularly, the present invention relates to method as defined in the introductory parts of claim 1, the use of the polymer produced by the method as defined in claim 12, a plastic component as defined in claim 9 and a light-emitting device as defined in claim 10.

### BACKGROUND OF THE INVENTION

In lighting devices, it is common to shift the radiation wavelength of the lighting device light source so that the lighting device emits light having a desired wavelength spectrum for the intended lighting purpose. In fluorescent tubes, e.g. a gas discharge produces UV-radiation which is converted to visible light having a desired wavelength spectrum by using a mixture of different phosphorescent materials on the inside of the glass tube of the fluorescent tube. More recent technology of Light Emitting Diodes (LED) also uses the same principle of light conversion. Warm white LEDs are often built by a LED emitting a sharp emission line in the deep blue region and a phosphor that shifts part of the LED light into a broad spectrum peak of yellow and red, which in combination with the generic LED light is perceived as warm white light.

Incorporating inorganic particles, for instance inorganic phosphor material, into a plastic material has the benefit to enable production of shaped components, making use of the characteristics of the inorganic particles. In the case of phosphors, the light conversion property is possible to utilize in a plastic part, e.g. in the outer plastic part of a bulb of a lighting device. Having the phosphor remote from the LED chip, also results in higher efficiency LED illumination systems compared to applying the phosphor directly on the LED.

Incorporating phosphor material in plastic is normally done by mixing the inorganic particles to the polymer by means of an extrusion process to make a compound. The mixing properties of the extruder are essential for the final compound properties and so for the final product properties.

However, the friction in the extruder and the very high shear forces during mixing in combination with the hardness of the inorganic particles leads to abrasion of the metal parts of the extruder. This leads to unwanted metal contamination of the compound and to possible deterioration of the inorganic particle properties. This, in turn, leads to efficiency losses in the light conversion leading to lower efficiency or poorer color of the light from a lighting device. The problem of friction during mixing is particularly evident when producing light conversion film having high inorganic particle concentrations.

This problem is partly solved by introducing the particles into the melt of the polymer by using a side feeder. However, still there are issues with too low efficiency, and it leads to another problem. Variation in particle concentration in the polymer due to variation in feeding rate ratio main versus side feeder leads to quality issues in the plastic light conversion product.

### SUMMARY OF THE INVENTION

It is an object of the present invention to improve the current state of the art, to solve the above problems, and to provide an improved method for manufacturing plastic parts having incorporated light shifting luminescent material particles. These and other objects are achieved by a method for producing a polymer product having integrated luminescent material particles, the polymer product being produced from at least one monomer in liquid phase and at least one kind of powder of luminescent material particles. The method is characterized by adding the luminescent material to the "liquid" monomer before polymerisation.

The polymerisation process, in which process the liquid monomer-particle mixture turns into a solid, incorporates the luminescent material particles in the polymer without friction and shear, such that the particle properties are not altered. The particles can withstand normal polymerisation conditions without being affected. In any further processing to shape the final component, e.g. further compounding, injection (blow) moulding or (film) extrusion, friction and high shear will be applied to the polymer and thus also to the luminescent material particles. By incorporating the particles before polymerisation, they receive a polymer layer which protects them against friction and high shear forces in an extrusion process. This means that the further processing of the polymer may be performed without deterioration of the properties of the luminescent material particles.

Later compounding of the polymer having particles incorporated already in the monomer stage according to the present invention is also enhanced by the inventive method. Since abrasion of equipment is significantly decreased, further compounding can be more thoroughly done without substantially increasing wear of the machines.

It is preferred that the method according to the present invention is performed using a polymer or a copolymer of that polymer, wherein said polymer is one contained in the group of: poly(ethylene terephthalate) or (PET), polyethylene naphthalate (PEN), poly(ethylene oxide) or PEO, polyamide (nylon) or PA, polycarbonate or PC, and poly(methyl methacrylate) or PMMA cyclic olefine copolymer (COC), polyimide (PI), polystyrene (PS) or a mixture thereof. Any polymer that is suitable for being part of a lighting device where incorporation of luminescent particles is desired is, however, possible to be manufactured using the method according to the invention.

The monomers that are polymerised in the invention may be any mixture of monomers which can polymerise to a polymer. Examples of monomers that may be used in the method of the invention are the monomers contained in the group of: terephthalic acid, ethylene glycol, or combination thereof.

Plastic manufacturing is a large industry with a lot of standard manufacturing methods. Since the method of adding luminescent particles to the monomer prior to polymerisation is possible to use with currently used polymers, and since the manufacturing equipment is essentially not worn by the incorporated particles when using the method according to the invention, the inventive method will save costs in the manufacturing stage. Manufacturers that otherwise might hesitate to produce particle containing plastic due to wear of equipment may now consider doing so.

Since the luminescent properties of the luminescent particles are affected by wear and friction to the particles, and metal particles torn from e.g. extruding equipment when mixing particles contaminate the plastic, the inventive method, where these effects are essentially avoided, also leads to higher efficiency of the light converting plastic part than plastic parts manufactured according to prior art technology.

The luminescent material used in the inventive method for producing a polymer product is according to one embodiment of the present invention a phosphorescent material emitting phosphorescence after absorption of radiation. According to a further embodiment of the present invention the luminescent material is a fluorescent material emitting fluorescence after absorption of radiation. The choice of luminescent material is dependent on the desired wavelength spectrum of the lighting device. Fluorescent materials, may be used if a very high temporal response is desired, due to its fast light conversion in the nanosecond range. Inorganic phosphor materials are, however, traditionally most used for light conversion, having a light conversion delay of a few microseconds up to seconds. The long emission lifetime of phosphor materials may be advantageous when used with LED light sources, since fast fluctuation in LED emission are smoothed by the long emission lifetime of the phosphor materials. The phosphorescent or fluorescent material may also be an organic material.

The luminescent particles according to the invention are often small and provided as a powder wherein the particles are sorted by size so that they have a narrow normal or log-normal size distribution. The luminescent material particles in said powder may have a median size in the range of 10 nm - 1 mm. More preferably, the luminescent material particles in said powder have a median size in the range of 1 µm - 20 µm. It should however be noted that the inventive method will work with all sizes of luminescent particles.

According to one embodiment of the inventive method the luminescent material particles are one or several of the materials contained in the group of: Y₃Al₅0₁₂:Ce³⁺ (YAG:Ce), Y₃Al₅0₁₂:Dy (YAG:Dy), Lu₃Al₅0₁₂:Ce³⁺ (LuAG:Ce), Lumogen F Red 305, Lumogen F Yellow 083, CaS:Eu²⁺, (Ba,Sr)₂Si₅N₈:Eu²⁺ (BSSN:Eu), Y₃Al₅O₁₂:Ce³⁺ Lu₃Al₅O₁₂:Ce, (Ba,Sr,Ca)₂Si₅N₈:Eu, (Sr,Ca)S: Eu²⁺, and (Ca,Sr)AlSiN₃:Eu²⁺, Sr₂Si₂N₂0₂:Eu²⁺, SrGa₂S₄: Eu²⁺, or a combination thereof. The garnet luminescent materials YAG:Ce and LuAG:Ce can be replaced by (Y₃-ₓ-_{y}LuₓGdy)(Al₅-_{z}si_{z})(O₁₂-_{z}N_{z}) :Ce having 0<x≤3 , 0≤y≤2.7, 0<x+y≤3 and O<z≤2. The luminescent materials could further be an organic phosphorescent material as perylene derivatives such as lumogen F materials (e.g. 083 (yellow), 170 (yellow), 240 (orange), 305 (red), 850 (green), difluoro-boraindacene derivatives (BODIPY), Fluorescein dyes , fluerene derivatives, coumarin dyes, xanthene dyes, pyrromethene-BF2 (P-BF2) complexes, Stilbene derivatives, Rodamine dyes, perylene carboximide dyes, and luminescent polymers such as polyphenylenevinilene (PPV), polyphenyl derivatives. The choice of luminescent material depends on the desired wavelength shift, the emission wavelength of the light source etc. Any luminescent material or a combination of luminescent materials that has absorption of the light source emission leading to frequency shifted luminescence from the luminescent material may, however, be used.

The present invention further relates to a plastic component, for light conversion made of the polymer produced according to the method described above. The plastic component can be a film, an injection molded component, an extruded profile, etc. The present invention still further relates to a light-emitting device comprising the plastic component. The light emitting device could be a light bulb for a lamp comprising a socket and a light source attached to the socket, and a shell surrounding the light source, wherein the shell is at least partly made of the polymer produced according to the method described above. The shell may be entirely made of the polymer having incorporated luminescent particles according to the present invention or the shell may be covered on the outside or the inside by a plastic film containing a polymer according to the present invention, having incorporated luminescent particles.

The light source of the light bulb is preferably a LED. LEDs usually have very sharp emission lines, why a wavelength shift often is desired to produce a light that is convenient and more similar to continuous spectral light sources as e.g. the incandescent light source and the sun.

The present invention further relates to the use of a polymer produced according to the method above in a lighting device.

It is noted that the invention relates to all possible combinations of features recited in the claims.

### DETAILED DESCRIPTION

The method according to the present invention is performed as follows. Before the polymerisation process, upon which the "liquid" monomer or monomer mixture turns into a solid, inorganic particles, poured in as a powder, are incorporated in the liquid monomer melt. The mixture of particles and monomer(s) is then polymerized into a polymer. The incorporated particles are in the polymerisation step covered by a layer of polymer that serves as protection against friction. The polymer is shaped into pellets or nurdles and later used as material for manufacturing plastic light converting details.

The pellets having incorporated luminescent particles may be produced to have a very high concentration of particles so that the polymer with luminescent particles may serve as a master batch that can be diluted with a standard polymer without incorporated particles to a mixture of desired particle concentration. Since the polymer layer protects the particles during processing with particle free polymer, the particles and their luminescent properties are unaffected by the processing.

The polymer having a desired concentration of luminescent particles may be formed to a plastic detail by e.g. injection moulding or film extrusion. During any of these processes high friction and high shear will be applied to the polymer. The protective layer of the luminescent particles, will, however, protect the equipment from abrasion and protect the polymer from pollution of metal particles otherwise torn and worn from the moulding or extrusion equipment.

Below an example of a remote phosphor film for TLED application will be described. The polymer used is PET (Polyethylene terephthalate), a commonly used polymer for many different applications. Its monomer (bis-β-hydroxyterephthalate) may be synthesized by the esterification between terephthalic acid and ethylene glycol, or by transesterification between ethylene glycol and dimethyl terephthalate. Polymerisation is done through a polycondensation reaction of the monomers (done immediately after esterification/transesterification) with water as the byproduct.

To form the polymer into a film, the industrial standard shaping technology film extrusion and biaxial stretching is used.

Before the polymerisation of the monomer into the PET polymer, the inorganic yellow phosphor particles YAG:Ce are added to the monomers. During polymerisation, the inorganic particles have been incorporated into the polymer without the pickup of metal contamination because of the mild polymerisation conditions compared to compounding.

The resulting polymer may be used directly, or if highly doped as a master batch, in the shaping process, which in this case is biaxially stretched film extrusion. In a film the needed concentration of inorganic phosphor particles is quite high, since the film is usually very thin compared to a moulded plastic detail. This makes it even more challenging to produce such a film while maintaining the particle properties. With the present invention, however, production of such a film with sufficiently high concentration of particles is possible.

To prove the invention two comparative examples were made:

### Example 1:

A film was prepared using a lab extruder with YAG incorporated in PET according to the inventive method. The YAG powder was added to the monomers and mixed with Lumogen F Red 305. The resulting light emission from the plastic detail showed visually and spectrally good properties/quality and the light conversion showed good efficiency.

### Example 2:

A film was prepared using the same lab extruder with YAG incorporated in PET according to the prior art way, i.e. the YAG powder was added to the polymer during compounding and mixture with Lumogen F Red 305. The resulting light emission from the plastic detail showed visually and spectrally poor properties/qualities and the light conversion showed poor efficiency.

The person skilled in the art realizes that the present invention by no means is limited to the preferred embodiments described above. On the contrary, many modifications and variations are possible within the scope of the appended claims.

## Claims

1. Method for producing a polymer product having integrated luminescent material particles, the polymer product being produced from at least one monomer in liquid phase and at least one kind of powder of luminescent material particles, comprising the step of adding the luminescent material to the monomer before polymerisation.

2. Method for producing a polymer product according to claim 1, wherein said polymer product comprises a polymer or a copolymer of that polymer , said polymer being one contained in the group of:
polyethylene terephthalate (PET), polyethylene naphthalate (PEN), poly(ethylene oxide) or PEO, polyamide (nylon) or PA, polycarbonate orPC, and poly(methyl methacrylate) or PMMA cyclic olefine copolymer (COC), polyimide (PI), polystyrene (PS)
or a mixture thereof.

3. Method for producing a polymer product according to any one of the preceding claims, wherein at least one monomer is one or a combination of the monomers contained in the group of: terephthalic acid, ethylene glycol.

4. Method for producing a polymer product according to any one of the preceding claims, wherein the luminescent material is a phosphorescent material emitting phosphorescence after absorption of radiation.

5. Method for producing a polymer product according to any one of the preceding claims, wherein the luminescent material is a fluorescent material emitting fluorescence after absorption of radiation.

6. Method for producing a polymer product according to any one of the preceding claims, wherein the luminescent material particles in said powder have a median size in the range of 10 nm - 1 mm.

7. Method for producing a polymer product according to any one of the preceding claims, wherein the luminescent material particles in said powder have a median size in the range of 1 µm - 20 µm.

8. Method for producing a polymer product according to any one of the preceding claims, wherein the luminescent material particles are one or several of the materials contained in the group of:
YAG:Ce, LuAG:Ce, Lumogen F Red 305, Lumogen F Yellow 083, or a combination thereof.

9. A plastic component for light conversion made of the polymer produced according to any one of claims 1-8.

10. Light-emitting device comprising the plastic component of claim 9.

11. Light-emitting device according to claim 10, wherein the light source is a LED.

12. Use of a polymer produced according to any one of claims 1-8 in a lighting device.
